(19) Europäisches Patentamt / European Patent Office / Office européen des brevets

(11) **EP 4 257 996 B1**

(12) **EUROPEAN PATENT SPECIFICATION**

(45) Date of publication and mention
of the grant of the patent:
**29.10.2025   Bulletin 2025/44**

(21) Application number: **22883793.6**

(22) Date of filing: **22.09.2022**

(51) International Patent Classification (IPC):
*H02J 7/00* (2006.01)      *H01M 10/48* (2006.01)
*B60L 58/12* (2019.01)      *B60L 58/18* (2019.01)
*B60L 58/22* (2019.01)      *G01R 31/396* (2019.01)

(52) Cooperative Patent Classification (CPC):
**G01R 31/396; B60L 58/12; B60L 58/18;
B60L 58/22; H01M 10/48; H01M 10/482;
H02J 7/0013; H02J 7/0047;** B60L 2240/545;
B60L 2240/547; B60L 2240/549; H02J 7/0048;
Y02E 60/10

(86) International application number:
**PCT/KR2022/014182**

(87) International publication number:
**WO 2023/068569 (27.04.2023 Gazette 2023/17)**

(54) **PARALLEL BATTERY SYSTEM AND METHOD OF PREDICTING REMAINING CHARGE TIME OF PARALLEL BATTERY SYSTEM**

PARALLELES BATTERIESYSTEM UND VERFAHREN ZUR VORHERSAGE DER VERBLEIBENDEN LADEZEIT DAVON

SYSTÈME DE BATTERIE PARALLÈLE ET PROCÉDÉ DE PRÉDICTION DU TEMPS DE CHARGE RESTANT DE CELUI-CI

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **18.10.2021   KR 20210138650**

(43) Date of publication of application:
**11.10.2023   Bulletin 2023/41**

(73) Proprietor: **LG Energy Solution, Ltd.
Seoul 07335 (KR)**

(72) Inventors:
• **KO, Youngjun
Daejeon 34122 (KR)**
• **JANG, Jihoon
Daejeon 34122 (KR)**

(74) Representative: **Plasseraud IP
104 Rue de Richelieu
CS92104
75080 Paris Cedex 02 (FR)**

(56) References cited:
WO-A1-2010/144023      CN-A- 111 890 986
JP-A- 2020 036 393       JP-B2- 3 692 617
JP-B2- 5 979 235         KR-A- 20190 083 897
KR-A- 20200 025 495      US-A1- 2015 066 837
US-A1- 2020 309 857

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**[Technical Field]**

CROSS REFERENCE TO RELATED APPLICATION(S)

This application claims benefit of priority to Korean Patent Application No. 10-2021-0138650 filed on October 18, 2021, in the Korean Intellectual Property Office.

The present invention relates to a parallel battery system and a method of predicting remaining charge time of the parallel battery system.

**[Background Art]**

Electric vehicles receive power from a battery system, and the battery system includes a plurality of battery packs. The plurality of battery packs may be connected in parallel to each other or may be connected in series to each other or battery packs connected in parallel in a predetermined unit may be connected in series, according to the amount of power to be supplied to the battery system.

In the case of a battery system in which two or more battery packs have a parallel structure, compared with a battery system in which two or more battery packs have a series structure, there are matters to be considered to predict a remaining charge time. The reason is because each of the plurality of battery packs connected in parallel involves a relay control. An effective technology for predicting a remaining charge time according to a state of each battery pack connected in parallel and relay control is required.

Document WO 2010/144023 discloses a method and arrangement for determining a resulting charging duration to be used for charging at least one starter battery in a dual battery system.

Document US 2020/309857 discloses methods, systems, and devices for estimating and predicting battery properties, such as state of charge (SOC).

Document US 2015/066837 discloses a method for predicting the duration of a future charging process for a vehicle battery.

Document CN 111 890 986 discloses a method for estimating the remaining charging time of a power battery based on self-updating data interpolation.

**[Disclosure]**

**[Technical Problem]**

The present invention has been made in an effort to provide a method for effectively predicting a remaining charge time according to a state of each of battery packs connected in parallel and a relay control in a battery system in which two or more battery packs are connected in parallel.

**[Technical Solution]**

An example embodiment of the present invention provides a method of predicting a remaining charge time to charge a plurality of battery packs connected in parallel up to a final target state of charge (SOC) as defined in the appended claims.

Another example embodiment of the present invention provides a battery system.

**[Advantageous Effects]**

In a battery system in which two or more battery packs are connected in parallel, a remaining charge time may be effectively predicted by providing an effective method of predicting a remaining charge time according to a state of each battery pack connected in parallel and a relay control.

**[Brief Description of the Drawings]**

FIG. 1 is a diagram illustrating a configuration of a battery system and an external device connected to the battery system according to an example embodiment.

FIG. 2 is a flowchart illustrating a method of predicting a remaining charge time according to an example embodiment.

FIG. 3 is a diagram schematically illustrating a plurality of battery packs and a charge state of each battery pack to explain a method of predicting a remaining charge time of FIG. 2.

FIG. 4 is a flowchart illustrating a method of predicting a remaining charge time according to an example embodiment.

**[Embodiments of the Invention]**

Hereinafter, example embodiments of the present invention will be described with reference to the accompanying drawings, in which like numbers refer to like elements throughout although the example embodiments are different, and a redundant description thereof is omitted. In the following description, usage of suffixes such as "module," "part," or "unit" used for referring to elements is given merely to facilitate explanation of the present invention, without having any significant meaning by itself. In describing the present invention, if a detailed explanation for a related known function or construction is considered to unnecessarily divert the gist of the present invention, such explanation has been omitted but would be understood by those skilled in the art. The accompanying drawings of the present invention aim to facilitate understanding of the present invention and should not be construed as limited to the accompanying drawings.

It will be understood that, although the terms first, second, etc. may be used herein to describe various elements, these elements should not be limited by these terms. These terms are only used to distinguish one element from another

It will be further understood that the terms "comprise" or "have" used in this specification, specify the presence of stated features, steps, operations, components, parts, or a combination thereof, but do not preclude the presence or addition of one or more other features, numerals, steps, operations, components, parts, or a combination thereof.

A program implemented as a set of instructions embodying a control algorithm necessary to control another configuration may be installed in a configuration for controlling another configuration under a specific control condition among configurations according to an example embodiment. The control configuration may process input data and stored data according to an installed program to generate output data. The control configuration may include a non-volatile memory to store a program and a memory to store data.

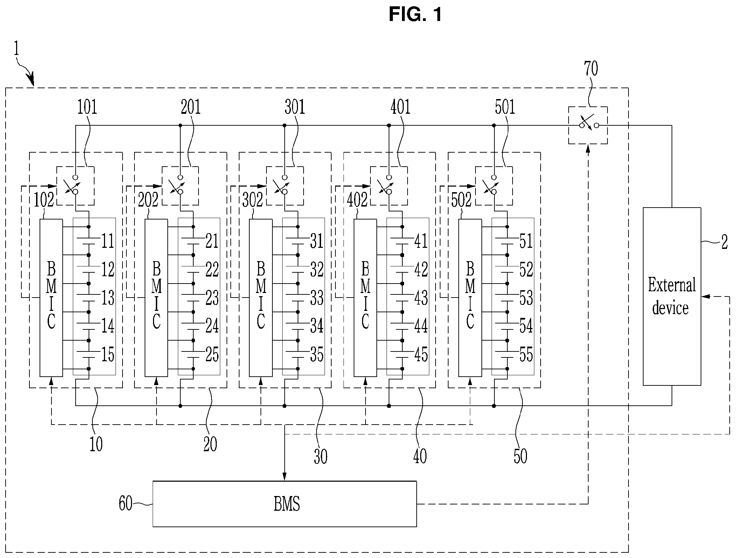

FIG. 1 is a diagram illustrating a configuration of a battery system and an external device connected to the battery system according to an example embodiment.

The battery system 1 includes a plurality of battery packs 10 to 50, a battery management system (BMS) 60, and a main relay 70. FIG. 1 shows that the number of the plurality of battery packs 10 to 50 is five, but the present invention is not limited thereto, and the battery system 1 may include two or more battery packs. Hereinafter, the battery management system 60 is referred to as a BMS.

An external device 2 may include a load, such as an inverter and a converter, and a charging device. One end of the main relay 70 is connected to the battery system 1, and the other end of the main relay 70 is connected to at least one component of the external device 2.

The plurality of battery packs 10 to 50 may be connected in parallel to each other, and each of the plurality of battery packs 10 to 50 may be connected in parallel to the external device 2 through the main relay 70. Each of the plurality of battery packs 10 to 50 includes a plurality of corresponding battery cells (e.g., 11 to 15) among the entire battery cells 11 to 15, 21 to 25, 31 to 25, 41 to 45, and 51 to 55, corresponding relays (e.g., 101) among the plurality of relays 101, 201, 301, 401, and 501, and corresponding pack battery monitoring integrated circuits (e.g., 102) among the plurality of pack battery monitoring integrated circuits 102, 202, 302, 402, and 502. Hereinafter, the battery monitoring integrated circuit is referred to as a BMIC.

A plurality of pack BMICs 102 to 502 are connected to a plurality of battery cells 11 to 15, 21 to 25, 31 to 25, 41 to 45, and 51 to 55, for example, 11 to 15, and obtain information on a cell voltage of each of the plurality of battery cells 11 to 15, 21 to 25, 31 to 25, 41 to 45, and 51 to 55, a battery current of the battery packs 10 to 50, a temperature of the battery packs 10 to 50, etc.

The BMS 60 may control charging and discharging of the plurality of battery packs 10 to 50 based on the battery pack voltage, battery pack current, battery pack temperature, etc., received from the plurality of pack BMICs 102 to 502, and may control a cell balancing operation on the plurality of battery cells 11 to 15, 21 to 25, 31 to 35, 41 to 45, and 51 to 55.

The BMS 60 may transmit a control signal for charging/discharging, a control signal for controlling a cell balancing operation, and the like to the plurality of pack BMICs 102 to 502 and the main relay 70. Each of the plurality of pack BMICs 102 to 502 may control opening and closing of a corresponding relay among the plurality of relays 101, 201, 301, 401, and 501 based on a corresponding control signal received from the BMS 60, and may control a cell balancing operation on each of the plurality of corresponding battery cells among the plurality of battery cells 11 to 15, 21 to 25, 31 to 35, 41 to 45, and 51 to 55.

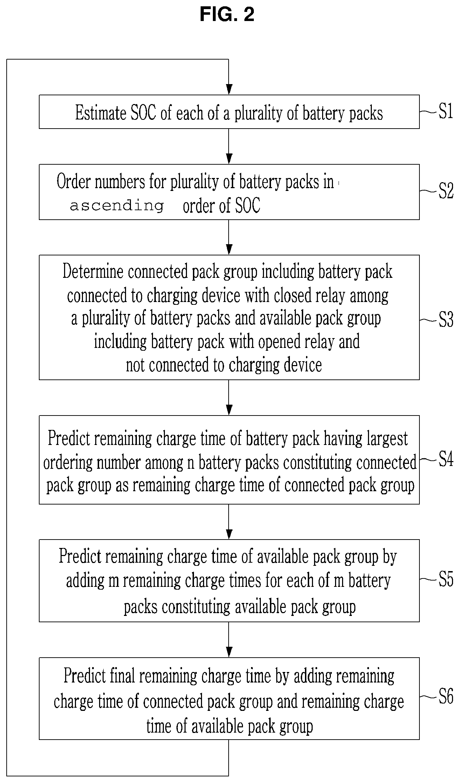

Hereinafter, a method of predicting a remaining charge time of the battery system 1 by the BMS 60 by receiving a battery pack voltage, a battery pack current, a battery pack temperature, and whether each of the plurality of relays 101 to 501 is opened or closed from the plurality of pack BMICs 102 to 502 will be described with reference to FIG. 2.

FIG. 2 is a flowchart illustrating a method of predicting a remaining charge time according to an example embodiment.

The BMS 60 estimates a state of charge (SOC) of each of the plurality of battery packs 10 to 50 (S1). The BMS 60 may estimate a charge state and the degree of a battery degradation of each battery pack 10 to 50 based on a battery cell voltage of each of the plurality of battery cells 11 to 15, 21 to 25, 31 to 35, 41 to 45, and 51 to 55 received from the plurality of pack BMICs 102 to 502, a battery pack current of the plurality of battery packs 10 to 50, and a battery pack temperature of the plurality of battery packs 10 to 50. Hereinafter, a charge state of the battery is referred to as a state of charge (SOC), and the degree of a degradation of the battery is referred to as a state of health (SOH) hereinafter.

The BMS 60 may estimate an SOC of each of the plurality of battery cells 11 to 15, 21 to 25, 31 to 35, 41 to 45, and 51 to 55 based on the information on the cell voltage of the plurality of battery cells 11 to 15, 21 to 25, 31 to 35, 41 to 45, and 51 to 55 and the battery current and temperature of the plurality of battery packs 10 to 50 received from the plurality of pack BMICs 102 to 502, and may estimate an SOC of each of the plurality of battery packs 10 to 50.

The BMS 60 may derive a representative SOC based on the SOC of a plurality of battery cells (e.g., 11 to 15) and estimate it as an SOC of the battery pack (e.g., 10). As a method of deriving the representative SOC, a method of deriving a maximum value, a minimum value, an average value, and the like may be used. When the battery pack (e.g., 10) is charged, a maximum value among the SOCs of the plurality of battery cells (e.g., 11 to 15) may be the representative SOC. The method of estimating the SOC of each of the plurality of battery cells 11 to 15, 21 to 25, 31 to 35, 41 to 45, and 51 to 55 may be one of various know methods, such as a current integration method, an SOC estimation method based on a battery equivalent circuit model, and a method of mixing the current integration method and an SOC estimation method based on an equivalent circuit model using a Kalman filter.

The BMS 60 orders numbers in ascending order of the SOC for the plurality of battery packs 10 to 50 (S2).

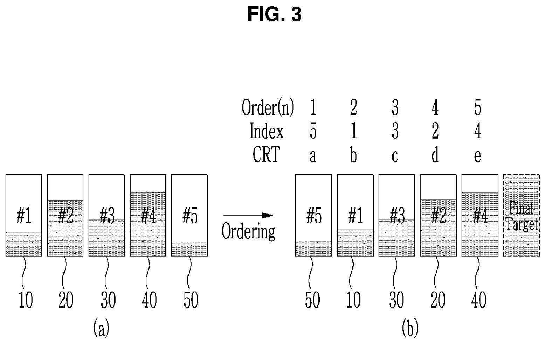

FIG. 3 is a diagram schematically illustrating a plurality of battery packs and a state of charge of each battery pack to explain a method of predicting a remaining charge time of FIG. 2.

Before ordering, the BMS 60 assigns an index number to each of the plurality of battery packs 10 to 50 to distinguish the plurality of battery packs 10 to 50 from each other. For example, in FIG. 3(a), the plurality of battery packs 10 to 50 are assigned with index numbers of 1, 2, 3, 4, and 5 sequentially from the left.

In FIG. 3, the SOC estimated in the plurality of battery packs 10 to 50 may be schematically represented as a width of a shaded area inside each battery pack. In FIG. 3(a), the arrangement of the index numbers according to the SOC of the plurality of battery packs 10 to 50 are 5, 1, 3, 2, and 4 in ascending order.

The BMS 60 may arrange the plurality of battery packs 10 to 50 in ascending order of the SOC and assign an ordering number to the plurality of battery packs 10 to 50 through step S2. The ordering number is a number assigned to each of the plurality of battery packs 10 to 50 when arranging the plurality of battery packs 10 to 50 in ascending order of the SOC.

For example, in FIG. 3(b), when the BMS 60 arranges the plurality of battery packs 10 to 50 in the ascending order of the SOC, they are arranged in the order of index numbers 5, 1, 3, 2 and 4. The BMS 60 may sequentially assign an ordering number to the plurality of arranged battery packs 10 to 50. Accordingly, the ordering numbers of the plurality of battery packs 10 to 50 are numbered 1, 2, 3, 4, and 5 sequentially from the left. Also, in FIG. 3(b), the index numbers of the plurality of battery packs 10 to 50 are 5, 1, 3, 2 and 4 in order from the left.

The BMS 60 may determine a final target SOC of the plurality of battery packs 10 to 50. For example, the BMS 60 may determine the final target SOC to be 95% of the SOC of a fully charged battery pack.

The BMS 60 may determine a connected pack group including a battery pack connected to the charging device with the relay 101 to 501 closed, among the plurality of battery packs 10 to 50 and an available pack group including a battery pack not connected to the charging device with the relays 101 to 501 opened (S3).

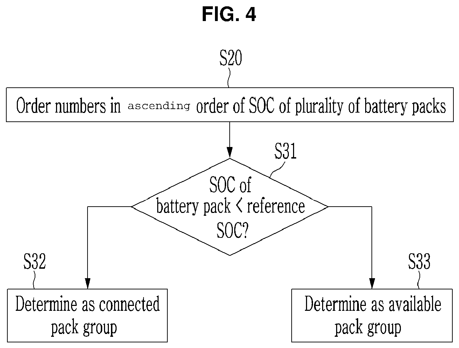

Hereinafter, an operation in which the BMS 60 determines a connected pack group and an available pack group may be described with reference to FIG. 4.

FIG. 4 is a flowchart illustrating a method of predicting a remaining charge time according to an example embodiment.

The BMS 60 orders the numbers in ascending order of the SOC of the plurality of battery packs 10 to 50 (S20) and determines whether the SOC of each battery pack 10 to 50 is less than a reference SOC (S31). As a result of the determination in step S31, a battery pack having an SOC less than the reference SOC is determined as a connected pack group (S32). As a result of the determination in step S31, a battery pack having an SOC equal to or greater than the reference SOC is determined as an available pack group (S33). Here, the reference SOC may be predetermined as initial information.

In the example of FIG. 3, the BMS 60 may determine the battery packs 50, 10, and 30 with ordering numbers 1, 2, and 3 as a connected pack group, and the battery packs 20 and 40 with ordering numbers 4 and 5 as an available pack group.

The relays 501, 101, and 301 of the battery packs 50, 10 and 30 constituting the connected pack group are controlled to a closed state by a control signal generated by the BMS 60. The relays 201 and 401 of the battery packs 20 and 40 constituting the available pack group are controlled to an open state by a control signal generated by the BMS 60. A control signal for controlling the opening or closing of the relay is generated in the BMS 60 and transmitted to the corresponding pack BMIC 102 to 502 of the battery pack, and the pack BMIC 102 to 502 may generate a relay driving control signal according to a control signal and supply the generated driving control signal to each relay 101 to 501.

To predict a final remaining charge time of the battery system 1, the BMS 60 derives a remaining charge time of the connected pack group and a remaining charge time of the available pack group.

Hereinafter, a remaining charge time estimating steps S4 to S6 will be described based on the example of FIG. 3.

The BMS 60 may predict a remaining charge time for the connected pack group and a remaining charge time for the available pack group.

The BMS 60 may estimate a remaining charge time of the battery pack unit by dividing remaining energy of the battery pack by power that may be supplied from the charging device. The remaining energy of the battery pack is a difference between the energy corresponding to a charging target SOC and the energy of a currently estimated SOC of the battery pack. The BMS 60 may store the energy of the battery pack corresponding to each SOC as a table. This is expressed by [Equation 1] below.

[Equation 1]

$$CRT = \frac{Remaining\ Energy(kW\hbar)}{Available\ Power(kW)}$$

The charging target SOC for the BMS 60 to select the remaining charge time for each battery pack may be differently determined based on whether the group to which each battery pack 10 to 50 belongs is a connected pack group or an available pack group.

The BMS 60 predicts a remaining charge time (e.g., c) of a battery pack having the largest ordering number, among n battery packs (e.g., 50, 10, and 30) constituting the connected pack group, as a remaining charge time of the connected pack group (S4). Here, n is a natural number. In the example of FIG. 3, n=3.

The BMS 60 may predict an expected time required for a battery pack having the highest SOC, among at least one battery pack belonging to the connected pack group, to reach the final target SOC as a remaining charge time of the connected pack group.

In other words, the BMS 60 assumes that the final target SOC (e.g., SOC 95%) is the charging target SOC in predicting the remaining charge time of the battery pack belonging to the connected pack group.

Referring to FIG. 3, the BMS 60 may predict a remaining charge time (c) for the battery pack 30 having the highest SOC, among the three battery packs 50, 10, and 30 included in the connected pack group, to reach the final target SOC, as the remaining charge time of the connected pack group.

Since the battery packs 50, 10, and 30 are connected in parallel to the charging device, 1/3 of charging power per one battery pack may be supplied. After charging of the battery packs 50, 10, and 30 is started, charging may be terminated when any one of the battery packs 50, 10, and 30 connected in parallel to the charging device reaches the target SOC. The use of the remaining charge time (c) of the battery pack 30 as a representative value as the remaining charge time of the connected pack group is because the battery pack 30, among the battery packs 50, 10, and 30 connected in parallel to the charging device, has the highest SOC before charging, so that the battery pack 30 may first reach the target SOC.

The BMS 60 predicts the remaining charge time of the available pack group by adding the m remaining charge times for each of the m battery packs (e.g., 20 and 40) constituting the available pack group (S5). Here, m is a natural number. In the example of FIG. 3, m=2.

The BMS 60 may predict the remaining charge time for each of the at least one battery pack belonging to the available pack group and may predict the remaining charge time for the available pack group by adding up the predicted remaining charge times.

Referring to FIG. 3, the BMS 60 may predict the remaining charge time of the available pack group by adding up the remaining charge time (d) of the battery pack 20 included in the available pack group and the remaining charge time (e) of the battery pack 40.

The BMS 60 may predict a charge time required for the estimated SOC of the battery pack 20 to reach the estimated SOC (charging target SOC) of the battery pack 40 corresponding to a next ordering number as the remaining charge time (d). The BMS 60 may predict the charge time required for the estimated SOC of the battery pack 40 having the largest ordering number of the available pack group to reach the final target SOC (charging target SOC) as the remaining charge time (e).

In other words, in predicting the remaining charge time of the battery pack having the largest ordering number, among the battery packs belonging to the available pack group, the BMS 60 assumes the estimated SOC of the battery pack corresponding to the next ordering number as the charging target SOC. In addition, in predicting the remaining charge time of the battery pack having the largest ordering number, among the battery packs belonging to the available pack group, the BMS 60 assumes that the final target SOC (e.g., SOC 95%) is the charging target SOC.

The sum (d+e) of the remaining charge times (d, e) of each of the battery packs 20 and 40 constituting the available pack group is the same as the charge time estimated to reach the final target SOC value based on the estimated SOC value of the battery pack 20 having the smallest ordering number, among the battery packs 20 and 40 constituting the available pack group.

As described above, in the method of predicting the remaining charge time according to an example embodiment, the remaining charge time of the connected pack group - battery packs 50, 10, and 30 - that may be connected to the charging device and the remaining charge time of the usable available pack group - battery packs 20 and 40 - may be predicted in another way.

The BMS 60 predicts the final remaining charge time by adding the remaining charge time of the connected pack group and the remaining charge time of the available pack group (S6). A method in which the BMS 60 predicts the final remaining charge time of the battery system 1 may be expressed by Equation 2 below.

[Equation 2]

$$CRT \ of \ ConnP = CRT \ of \ the \ Last \ number = c$$
$$CRT \ of \ AvailP = Sum \ of \ CRT \ of \ the \ AvailP = d + e$$
$$CRT = CRT \ of \ ConnP + \ CRT \ of \ AvailP = c + d + e$$

Here, CRT is the remaining charge time, ConnP is a connected battery pack group, and AvailP is an available battery pack.

When the charging of the battery packs 50, 10, and 30 constituting the connected pack group from the charging device is terminated, the BMS 60 may repeat steps S1 to S6 again.

Although example embodiments of the present invention have been described in detail above, the scope of the present invention is not limited thereto, and various modifications and improvements by those of ordinary skill in the field to which the present invention pertains are also within the scope of the present invention, which is defined by the appended claims.

**Claims**

1.  A method of predicting a remaining charge time to charge a plurality of battery packs (10, ..., 50) connected in parallel up to a final target state of charge, SOC, the method comprising:

    estimating (S1), by a battery management system, BMS, (60), an SOC of each of the plurality of battery packs (10, ..., 50);
    assigning (S2), by the BMS, an ordering number in ascending order of the SOC for the plurality of battery packs (10, ..., 50);
    determining (S3), by the BMS (60), a connected pack group including a battery pack connected to a charging device with a closed relay, among the plurality of battery packs (10, ..., 50), and an available pack group including a battery pack with an opened relay and not connected to the charging device;
    predicting (S4), by the BMS, a first remaining charge time required for a battery pack having the largest ordering number, among n battery packs constituting the connected pack group, to reach the final target SOC;
    predicting (S5), by the BMS, m remaining charge times for m battery packs constituting the available pack group, and calculating a second remaining charge time by adding the m remaining charge times; and
    predicting (S6), by the BMS (60), a final remaining charge time by adding the first remaining charge time and the second remaining charge time,
    wherein n and m are natural numbers.

2.  The method of claim 1, wherein:
    the estimating (S1) of the SOC of each of the plurality of battery packs (10, ..., 50) includes:
    estimating, by the BMS, the SOC of each of the plurality of battery packs (10, ..., 50) based on a cell voltage of each of the plurality of battery cells received from a battery monitoring integrated circuit, BMIC included in each of the plurality of battery packs (10, ..., 50), battery currents of the plurality of battery packs (10, ..., 50), and temperature information of the plurality of battery packs (10, ..., 50) .

3. The method of claim 1, wherein:
the determining (S3) of the connected pack group and the available pack group includes:
determining, by the BMS, a battery pack having the estimated SOC value less than a reference SOC value, among the plurality of battery packs (10, ..., 50), as the connected pack group.

4. The method of claim 1, wherein:
the determining (S3) of the connected pack group and the available pack group includes:
the determining, by the BMS (60), a battery pack having the estimated SOC value equal to or greater than a reference SOC value, among the plurality of battery packs (10, ..., 50), as the available pack group.

5. The method of claim 1, wherein:
the calculating the second remaining charge time includes:
predicting, by the BMS, a remaining charge time of a first battery pack, excluding a battery pack having a largest ordering number, among the m battery packs, as a charge time required for an estimated SOC of each of the first battery packs to reach an estimated SOC of a second battery pack corresponding to a next ordering number.

6. The method of claim 1, wherein:
the calculating of the second remaining charge time includes:
predicting, by the BMS (60), a remaining charge time of a third battery pack having the largest ordering number, among the m battery packs, as a charge time required for an estimated SOC of the third battery pack to reach the final target SOC.

7. A battery system comprising:

a plurality of battery packs (10, ..., 50) connected in parallel, and
a battery management system, BMS (60), adapted for carrying out the method of claim 1.

8. The battery system of claim 7, wherein:

the BMS (60) is configured to estimate
the SOC of each of the plurality of battery packs (10, ..., 50) based on a cell voltage of each of the plurality of battery cells received from a battery monitoring integrated circuit, BMIC included in each of the plurality of battery packs (10, ..., 50), battery currents of the plurality of battery packs (10, ..., 50), and temperature information of the plurality of battery packs (10, ..., 50).

9. The battery system of claim 7, wherein:

the BMS (60) is configured to set
a battery pack having the estimated SOC value less than a reference SOC value, among the plurality of battery packs (10, ..., 50) , as the connected pack group.

10. The battery system of claim 7, wherein:

the BMS (60) is configured to set
a battery pack having the estimated SOC value equal to or greater than a reference SOC value, among the plurality of battery packs (10, ..., 50), as the available pack group.

11. The battery system of claim 7, wherein:

the BMS (60) is configured to predict
a time required for the battery pack having the largest ordering number, among the n battery packs constituting the connected pack group, to reach the final target SOC, as the first remaining charge time, wherein n is a natural number.

12. The battery system of claim 7, wherein:

the BMS (60) is configured to predict
m remaining charge times for m battery packs constituting the available pack group, and calculates a second remaining charge time by adding the m remaining charge times, wherein m is a natural number.

**13.** The battery system of claim 12, wherein:

the BMS (60) is configured to predict
a charge time required for an estimated SOC of a first battery pack excluding the battery pack having the largest ordering number, among the m battery packs (10, ..., 50), to reach an estimated SOC of a second battery pack corresponding to a next ordering number, as a remaining charge time of the first battery pack.

**14.** The battery system of claim 13, wherein:

the BMS (60) is configured to predict
a remaining charge time of a third battery pack having the largest ordering number, among the m battery packs, as a charge time required for the estimated SOC of the third battery pack to reach the final target SOC, and calculates the second remaining charge time by adding the remaining charge time of the first battery pack and the remaining charge time of the third battery pack.

**Patentansprüche**

**1.** Verfahren zum Vorhersagen einer verbleibenden Ladezeit, um eine Mehrzahl von parallel verbundenen Batteriepacks (10, ..., 50) auf einen endgültigen Soll-Ladezustand, SOC, zu laden, wobei das Verfahren umfasst:

Abschätzen (S1) durch ein Batteriemanagementsystem BMS, (60), eines SOC von jedem der Mehrzahl von Batteriepacks (10, ..., 50);
Zuweisen (S2) durch das BMS einer Ordnungsnummer in aufsteigender Reihenfolge des SOC für die Mehrzahl von Batteriepacks (10, ..., 50);
Bestimmen (S3) durch das BMS (60) einer verbundenen Packgruppe, umfassend ein Batteriepack, welches mit einer Ladevorrichtung mit einem geschlossenen Relais verbunden ist, unter der Vielzahl von Batteriepacks (10, ..., 50), und einer verfügbaren Packgruppe, umfassend ein Batteriepack mit einem geöffneten Relais, welches nicht mit der Ladevorrichtung verbunden ist;
Vorhersagen (S4) durch das BMS einer ersten verbleibenden Ladezeit, welche für einen Batteriepack mit der größten Ordnungsnummer unter n Batteriepacks, welche die verbundene Packgruppe bilden, erforderlich ist, um den endgültigen Soll-SOC zu erreichen;
Vorhersagen (S5) durch das BMS von m verbleibenden Ladezeiten für m Batteriepacks, welche die verfügbare Packgruppe bilden, und Berechnen einer zweiten verbleibenden Ladezeit durch Addieren der m verbleibenden Ladezeiten; und
Vorhersagen (S6) durch das BMS (60) einer endgültigen verbleibenden Ladezeit durch Addieren der ersten verbleibenden Ladezeit und der zweiten verbleibenden Ladezeit,
wobei n und m natürliche Zahlen sind.

**2.** Verfahren nach Anspruch 1, wobei:
das Abschätzen (S1) des SOC von jedem der Mehrzahl von Batteriepacks (10, ..., 50) umfasst:
Abschätzen durch das BMS des SOC von jedem der Mehrzahl von Batteriepacks (10, ..., 50) basierend auf einer Zellspannung von jeder der Mehrzahl von Batteriezellen, welche von einer integrierten Batterieüberwachungsschaltung, BMIC, empfangen wird, welche in jedem der Mehrzahl von Batteriepacks (10, ..., 50) enthalten ist, Batterieströmen der Mehrzahl von Batteriepacks (10, ..., 50) und Temperaturinformationen der Mehrzahl von Batteriepacks (10, ..., 50).

**3.** Verfahren nach Anspruch 1, wobei:
das Bestimmen (S3) der verbundenen Packgruppe und der verfügbaren Packgruppe umfasst:
Bestimmen durch das BMS eines Batteriepacks mit dem geschätzten SOC-Wert, welcher kleiner als ein Referenz-SOC-Wert ist, unter der Mehrzahl von Batteriepacks (10, ..., 50), als die verbundene Packgruppe.

**4.** Verfahren nach Anspruch 1, wobei:
das Bestimmen (S3) der verbundenen Packgruppe und der verfügbaren Packgruppe umfasst:
das Bestimmen durch das BMS (60) eines Batteriepacks mit dem geschätzten SOC-Wert, welcher gleich oder größer als ein Referenz-SOC-Wert ist, unter den mehreren Batteriepacks (10, ..., 50) als die verfügbare Packgruppe.

**5.** Verfahren nach Anspruch 1, wobei:
das Berechnen der zweiten verbleibenden Ladezeit umfasst:
Vorhersagen durch das BMS einer verbleibenden Ladezeit eines ersten Batteriepacks, ausgenommen eines Batteriepacks mit einer größten Ordnungsnummer unter den m Batteriepacks, als eine Ladezeit, welche für einen geschätzten SOC von jedem der ersten Batteriepacks erforderlich ist, um einen geschätzten SOC eines zweiten Batteriepacks zu erreichen, welcher einer nächsten Ordnungsnummer entspricht.

**6.** Verfahren nach Anspruch 1, wobei:
das Berechnen der zweiten verbleibenden Ladezeit umfasst:
Vorhersagen durch das BMS (60) einer verbleibenden Ladezeit eines dritten Batteriepacks mit der größten Ordnungsnummer unter den m Batteriepacks als eine Ladezeit, welche für einen geschätzten SOC des dritten Batteriepacks erforderlich ist, um den endgültigen Soll-SOC zu erreichen.

**7.** Batteriesystem, umfassend:

eine Mehrzahl von parallel verbundenen Batteriepacks (10, ..., 50); und
ein Batteriemanagementsystem BMS (60), welches dazu angepasst ist, das Verfahren nach Anspruch 1 durchzuführen.

**8.** Batteriesystem nach Anspruch 7, wobei:

das BMS (60) dazu eingerichtet ist,
den SOC von jedem der Mehrzahl von Batteriepacks (10, ..., 50) basierend auf einer Zellspannung von jeder der Mehrzahl von Batteriezellen, welche von einer integrierten Batterieüberwachungsschaltung, BMIC, empfangen wird, welche in jedem der Mehrzahl von Batteriepacks (10, ..., 50) enthalten ist, Batterieströmen der mehreren Batteriepacks (10, ..., 50) und Temperaturinformationen der Mehrzahl von Batteriepacks (10, ..., 50) abzuschätzen.

**9.** Batteriesystem nach Anspruch 7, wobei

das BMS (60) dazu eingerichtet ist,
ein Batteriepack mit dem geschätzten SOC-Wert, welcher kleiner als ein Referenz-SOC-Wert ist, unter der Mehrzahl von Batteriepacks (10, ..., 50) als die verbundene Packgruppe festzulegen.

**10.** Batteriesystem nach Anspruch 7, wobei:

das BMS (60) dazu eingerichtet ist,
ein Batteriepack mit dem geschätzten SOC-Wert, welcher gleich oder größer als ein Referenz-SOC-Wert ist, aus der Vielzahl von Batteriepacks (10, ..., 50) als die verfügbare Packgruppe festzulegen.

**11.** Batteriesystem nach Anspruch 7, wobei:

das BMS (60) dazu eingerichtet ist,
eine Zeit vorherzusagen, welche für den Batteriepack mit der größten Ordnungsnummer unter den n Batteriepacks, welche die verbundene Packgruppe bilden, erforderlich ist, um den endgültigen Soll-SOC zu erreichen, als die erste verbleibende Ladezeit, wobei n eine natürliche Zahl ist.

**12.** Batteriesystem nach Anspruch 7, wobei

das BMS (60) dazu eingerichtet ist,
m verbleibende Ladezeiten für m Batteriepacks, welche die verfügbare Packgruppe bilden, vorherzusagen und eine zweite verbleibende Ladezeit durch Addieren der m verbleibenden Ladezeiten zu berechnen, wobei m eine natürliche Zahl ist.

**13.** Batteriesystem nach Anspruch 12, wobei:

das BMS (60) dazu eingerichtet ist,
eine Ladezeit vorherzusagen, welche für einen geschätzten SOC eines ersten Batteriepacks, ausgenommen des Batteriepacks mit der größten Ordnungsnummer, unter den m Batteriepacks (10, ..., 50) erforderlich ist, um einen geschätzten SOC eines zweiten Batteriepacks zu erreichen, welcher einer nächsten Ordnungsnummer entspricht, als eine verbleibende Ladezeit des ersten Batteriepacks.

**14.** Batteriesystem nach Anspruch 13, wobei:

das BMS (60) dazu eingerichtet ist,
eine verbleibende Ladezeit eines dritten Batteriepacks mit der größten Ordnungsnummer unter den m Batteriepacks als eine Ladezeit vorherzusagen, welche für den geschätzten SOC des dritten Batteriepacks erforderlich ist, um den endgültigen Soll-SOC zu erreichen, und die zweite verbleibende Ladezeit durch Addieren der verbleibenden Ladezeit des ersten Batteriepacks und der verbleibenden Ladezeit des dritten Batteriepacks berechnet.

## Revendications

**1.** Procédé de prédiction d'un temps de charge restant pour charger une pluralité de blocs-batteries (10, ..., 50) connectés en parallèle jusqu'à un état de charge, SOC, cible final, le procédé comprenant :

l'estimation (S1), par un système de gestion de batterie, BMS, (60), d'un SOC de chacun de la pluralité de blocs-batteries (10, ..., 50) ;
l'affectation (S2), par le BMS, d'un numéro d'ordre dans l'ordre croissant du SOC pour la pluralité de blocs-batteries (10, ..., 50) ;
la détermination (S3), par le BMS (60), d'un groupe de blocs connectés incluant un bloc-batteries connecté à un dispositif de charge avec un relais fermé, parmi la pluralité de blocs-batteries (10, ..., 50), et d'un groupe de blocs disponibles incluant un bloc-batteries avec un relais ouvert et non connecté au dispositif de charge ;
la prédiction (S4), par le BMS, d'un premier temps de charge restant nécessaire pour qu'un bloc-batterie ayant le plus grand numéro d'ordre, parmi n blocs-batteries constituant le groupe de blocs connectés, atteigne le SOC cible final ;
la prédiction (S5), par le BMS, de m temps de charge restants pour m blocs-batteries constituant le groupe de blocs disponibles, et le calcul d'un second temps de charge restant en additionnant les m temps de charge restants ; et
la prédiction (S6), par le BMS (60), d'un temps de charge restant final en additionnant le premier temps de charge restant et le deuxième temps de charge restant,
dans lequel n et m sont des nombres naturels.

**2.** Procédé selon la revendication 1, dans lequel :
l'estimation (S1) du SOC de chacun de la pluralité de blocs-batteries (10, ..., 50) inclut :
l'estimation, par le BMS, du SOC de chacun de la pluralité de blocs-batteries (10, ..., 50) sur la base d'une tension de cellule de chacune de la pluralité de cellules de batterie reçue en provenance d'un circuit intégré de surveillance de batterie, BMIC, inclus dans chacun de la pluralité de blocs-batteries (10, ..., 50), de courants de batterie de la pluralité de blocs-batteries (10, ..., 50), et d'informations de température de la pluralité de blocs-batteries (10, ..., 50).

**3.** Procédé selon la revendication 1, dans lequel :
la détermination (S3) du groupe de blocs connectés et du groupe de blocs disponibles inclut :
la détermination, par le BMS, d'un bloc-batterie dont la valeur de SOC estimée est inférieure à une valeur de SOC de référence, parmi la pluralité de blocs-batteries (10, ..., 50), en tant que groupe de blocs connectés.

**4.** Procédé selon la revendication 1, dans lequel :
la détermination (S3) du groupe de blocs connectés et du groupe de blocs disponibles inclut :
la détermination, par le BMS (60), d'un bloc-batterie dont la valeur de SOC estimée est égale ou supérieure à une valeur de SOC de référence, parmi la pluralité de blocs-batteries (10, ..., 50), en tant que groupe de blocs disponibles.

**5.** Procédé selon la revendication 1, dans lequel :
le calcul du deuxième temps de charge restant inclut :
la prédiction, par le BMS, d'un temps de charge restant d'un premier bloc-batterie, à l'exclusion d'un bloc-batterie ayant un numéro d'ordre le plus élevé, parmi les m blocs-batteries, en tant que temps de charge nécessaire pour qu'un SOC estimé de chacun des premiers blocs-batteries atteigne un SOC estimé d'un deuxième bloc-batterie correspondant à un numéro d'ordre suivant.

6. Procédé selon la revendication 1, dans lequel :
le calcul du second temps de charge restant inclut :
la prédiction, par le BMS (60), d'un temps de charge restant d'un troisième bloc-batterie ayant le plus grand numéro d'ordre, parmi les m blocs-batteries, en tant que temps de charge nécessaire pour qu'un SOC estimé du troisième bloc-batterie atteigne le SOC cible final.

7. Système de batterie comprenant :

une pluralité de blocs-batteries (10, ..., 50) connectés en parallèle ; et
un système de gestion de batterie, BMS (60), adapté pour réaliser le procédé selon la revendication 1.

8. Système de batterie selon la revendication 7, dans lequel :

le BMS (60) est configuré pour estimer
le SOC de chacun de la pluralité de blocs-batteries (10, ..., 50) sur la base d'une tension de cellule de chacune de la pluralité de cellules de batterie reçue en provenance d'un circuit intégré de surveillance de batterie, BMIC, inclus dans chacun de la pluralité de blocs-batteries (10, ..., 50), de courants de batterie de la pluralité de blocs-batteries (10, ..., 50), et d'informations de température de la pluralité de blocs-batteries (10, ..., 50).

9. Système de batterie selon la revendication 7, dans lequel :

le BMS (60) est configuré pour régler
un bloc-batterie dont la valeur de SOC estimée est inférieure à une valeur de SOC de référence, parmi la pluralité de blocs-batteries (10, ..., 50), en tant que groupe de blocs connectés.

10. Système de batterie selon la revendication 7, dans lequel :

le BMS (60) est configuré pour régler
un bloc-batterie dont la valeur de SOC estimée est égale ou supérieure à une valeur de SOC de référence, parmi la pluralité de blocs-batteries (10, ..., 50), comme groupe de blocs disponibles.

11. Système de batterie selon la revendication 7, dans lequel :

le BMS (60) est configuré pour prédire
un temps nécessaire pour que le bloc-batterie ayant le plus grand numéro d'ordre, parmi les n blocs-batteries constituant le groupe de blocs connectés, atteigne le SOC cible final, en tant que premier temps de charge restant, dans lequel n est un nombre naturel.

12. Système de batterie selon la revendication 7, dans lequel :

le BMS (60) est configuré pour prédire
m temps de charge restants pour m blocs-batteries constituant le groupe de blocs disponibles, et calcule un deuxième temps de charge restant en additionnant les m temps de charge restants, dans lequel m est un nombre naturel.

13. Système de batterie selon la revendication 12, dans lequel :

le BMS (60) est configuré pour prédire
un temps de charge nécessaire pour qu'un SOC estimé d'un premier bloc-batterie à l'exclusion du bloc-batterie ayant le numéro d'ordre le plus élevé, parmi les m blocs-batteries (10, ..., 50), atteigne un SOC estimé d'un deuxième bloc-batterie correspondant à un numéro d'ordre suivant, en tant que temps de charge restant du premier bloc-batterie.

14. Système de batterie selon la revendication 13, dans lequel :

le BMS (60) est configuré pour prédire

un temps de charge restant d'un troisième bloc-batterie ayant le plus grand numéro d'ordre, parmi les m blocs-batteries, en tant que temps de charge nécessaire pour que le SOC estimé du troisième bloc-batterie atteigne le SOC cible final, et calcule le deuxième temps de charge restant en additionnant le temps de charge restant du premier bloc-batterie et le temps de charge restant du troisième bloc-batterie.

# FIG. 1

**FIG. 2**

Estimate SOC of each of a plurality of battery packs — S1

Order numbers for plurality of battery packs in
ascending order of SOC — S2

Determine connected pack group including battery pack
connected to charging device with closed relay among
a plurality of battery packs and available pack group
including battery pack with opened relay and
not connected to charging device — S3

Predict remaining charge time of battery pack having largest
ordering number among n battery packs constituting connected
pack group as remaining charge time of connected pack group — S4

Predict remaining charge time of available pack group by
adding m remaining charge times for each of m battery
packs constituting available pack group — S5

Predict final remaining charge time by adding remaining
charge time of connected pack group and remaining charge
time of available pack group — S6

**FIG. 3**

(a)

(b)

| Order(n) | 1 | 2 | 3 | 4 | 5 |
|----------|---|---|---|---|---|
| Index | 5 | 1 | 3 | 2 | 4 |
| CRT | a | b | c | d | e |

# FIG. 4

S20

Order numbers in ascending order of SOC of plurality of battery packs

S31

SOC of
battery pack < reference
SOC?

S32

Determine as connected
pack group

S33

Determine as available
pack group

**EP 4 257 996 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020210138650
- WO 2010144023 A
- US 2020309857 A
- US 2015066837 A
- CN 111890986